# EUROPÄISCHE PATENTSCHRIFT

(11) **EP 1 269 410 B1**
(45) Veröffentlichungstag und Bekanntmachung des Hinweises auf die Patenterteilung: **26.11.2003**
(21) Anmeldenummer: 01921320.6
(22) Anmeldetag: 07.03.2001
(51) Int. Cl.: G06K 19/077

(54) **VERFAHREN ZUR HERSTELLUNG EINES TRÄGERBANDES MIT EINER VIELZAHL VON ELEKTRISCHEN EINHEITEN, JEWEILS AUFWEISEND EINEN CHIP UND KONTAKTELEMENTE**
METHOD FOR PRODUCING A CARRIER STRIP COMPRISING A LARGE NUMBER OF ELECTRICAL UNITS, EACH HAVING A CHIP AND CONTACT ELEMENTS
PROCEDE POUR FABRIQUER UNE BANDE SUPPORT DOTEE D'UNE MULTITUDE D'UNITES ELECTRIQUES PRESENTANT CHACUNE UNE PUCE ET DES ELEMENTS DE CONTACT

(30) Priorität: 24.03.2000 DE 10014620
(43) Veröffentlichungstag der Anmeldung: 02.01.2003
(73) Patentinhaber: Plettner, Andreas, Dr., 81669 München (DE)
(72) Erfinder: Plettner, Andreas, Dr., 81669 München (DE)
(74) Vertreter: Grünecker, Kinkeldey, Stockmair & Schwanhäusser Anwaltssozietät
(86) Internationale Anmeldenummer: EP0102572
(87) Internationale Veröffentlichungsnummer: WO01073686

(56) Entgegenhaltungen:
- DE-A- 19 651 566
- DE-A- 19 701 167
- FR-A- 2 761 527
- US-A- 5 946 198

## Beschreibung

Die vorliegende Erfindung bezieht sich auf ein Verfahren zur Herstellung eines Trägerbandes mit einer Vielzahl von elektrischen Einheiten, jeweils aufweisend einen Chip und Kontaktelemente, gemäß dem Oberbegriff des Patentanspruchs 1. Verfahrens anspruch 1 zeigt im Oberbegriff der Merkmale soweit sie aus US-A-5 946 198 bekannt sind.

Kontaktlose Chipkarten lösen zunehmend kontaktbehaftete Chipkarten ab. Der Grund hierfür dürfte insbesondere darin zu sehen sein, dass kontaktlose Chipkarten eine einfachere Handhabung gestatten, robuster ausgestaltet sind und somit eine geringere Störanfälligkeit aufweisen und eine Reihe interessanter neuer Möglichkeiten in der Anwendung bieten, da sie nicht in ein Lesegerät eingesteckt werden müssen.

Kontaktlose Chipkarten weisen bekanntermaßen eine in die Chipkarte eingebrachte Leiterschleife oder Antenne auf, mittels der der ebenfalls in die Chipkarte eingebrachte Chip mit der Außenwelt kommunizieren kann. Hierzu muss während der Herstellung der kontaktlosen Chipkarte die Leiterschleife mit den Kontakten des Chips bzw. des entsprechenden Moduls verbunden werden. Zur Erzielung dieser elektrischen Verbindung zwischen Leiterschleife und Chip wurden bereits mehrere Verfahren vorgeschlagen, wobei sich insbesondere die Verwendung eines Chipmoduls und eine Kontaktierung eines "nackten" Chips, d.h. des Chips selbst und nicht in Modulform, mittels "Flip-Chip"-Prozeß oder durch Drahtbonden durchgesetzt haben.

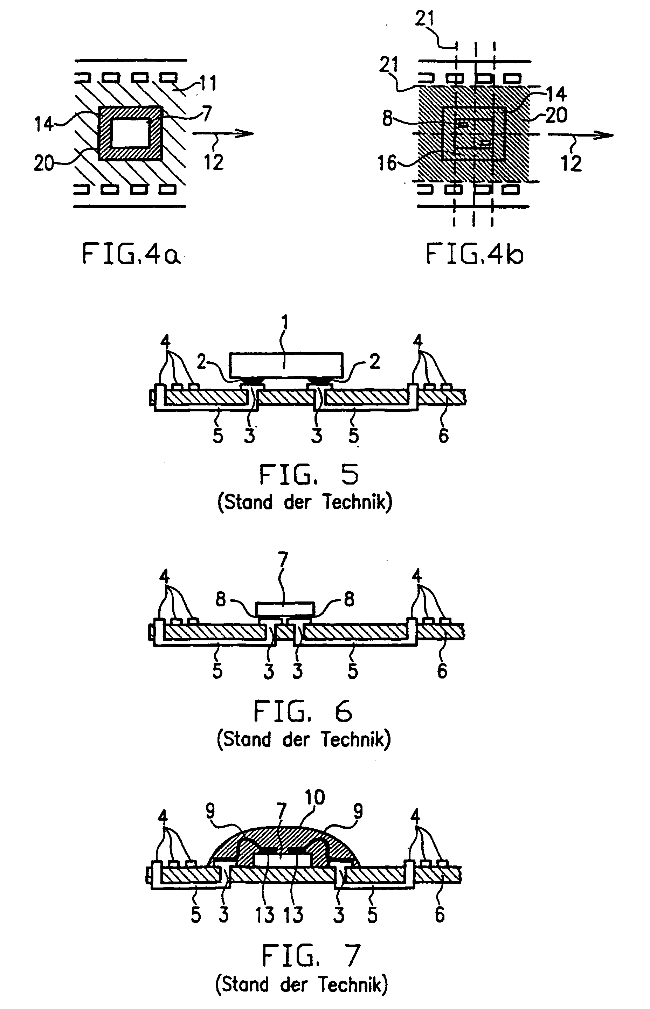

Fig. 5 verdeutlicht das Prinzip, wie nach dem Stand der Technik üblicherweise eine elektrische Verbindung zwischen einem Chipmodul 1 und einer Leiterschleife 4 hergestellt wird.

Ein Chipmodul 1, in dessen inneren sich ein nicht dargestellter Chip befindet, weist von außen zugängliche Kontakte 2 auf, die beispielsweise mittels eines Löt-, Klebeoder Drahtbondprozesses mit den eigentlichen Kontakten des Chips verbunden sind. Mit der Bezugsziffer 3 sind Kontaktanschlüsse angedeutet, die über einen elektrischen Leiter 5 zu der auf einem Chipkartenkörper 6 aufgebrachten Leiterschleife 4 eine elektrische Verbindung herstellen. Um letztendlich eine Kontaktierung zwischen der Leiterschleife 4 einerseits und dem Chip andererseits zu erreichen, müssen die Kontakte 2 mit den Kontaktanschlüssen 3 elektrisch leitend verbunden werden. Hierzu wird das Modul 1 mittels eines Werkzeuges mit der kontaktbehafteten Seite auf die Kontaktanschlüsse 3 aufgesetzt.

Fig. 6 verdeutlicht eine andere Möglichkeit, die darin besteht, den nackten Chip 7 mittels Flip-Chip-Verfahren auf die Kontaktanschlüsse 3 aufzusetzen. Bei dieser Variante muss der Chip 7 mit seiner "aktiven Seite", d.h. der Seite, die die Anschlußflächen 8 trägt, auf die Anschlüsse 3 aufgesetzt werden. Hierzu ist ein "Flippen" des Chips 7 erforderlich, was ein zweifaches Greifen des Chips 7 vom Trägerband bzw. vom Wafer erforderlich macht.

Fig. 7 verdeutlicht, wie nach dem Stand der Technik eine elektrische Verbindung zwischen einem Chip 7 und einer Leiterschleife 4 mittels Drahtbonden hergestellt werden kann.

Um in diesem Fall eine Kontaktierung zwischen der Leiterschleife 4 einerseits und dem Chip 7 andererseits zu erreichen, wird der Chip 7 auf den Chipkartenkörper 6 aufgebracht, und die Kontakte 8 werden mittels Drahtbonden mit den Kontaktanschlüssen 3 elektrisch leitend verbunden. Ersichtlicherweise muss der Chip 7 bei dieser Lösung nicht mehr geflippt werden. Allerdings bedingen die durch das Drahtbonden entstandenen Drahtverbindungen 9 eine größere Gesamtbauhöhe der Chipkarte und müssen außerdem durch eine solide Schutzschicht 10 geschützt werden.

Eine andere Art der Kontaktierung ist aus DE 196 09 636 C1 bekannt. Gemäß der dort angegebenen Lösungsmöglichkeit wird ein Chipmodul derart in eine Aussparung des Chipkartenkörpers eingebracht, dass die auf der Oberfläche des Moduls vorhandenen Kontakte bündig mit Leiterbahnen auf der Oberfläche des Körpers abschließen, sodass hierdurch eine Kontaktierung der Leiterschleife mit den Kontakten des Moduls erzielt werden kann. Nachteilig bei dieser Ausführung ist, dass die Tiefe der Aussparung äußerst genau bemessen sein muss, um das plane Abschließen der beiden Kontakte zu ermöglichen.

Ausgehend von dem bekannten Stand der Technik liegt der vorliegenden Erfindung die Aufgabe zugrunde, eine Möglichkeit zu schaffen, Kontakte zwischen einem Chip und der Antenne einer kontaktlosen Chipkarte einfacher und insbesondere schneller zu erstellen, wobei diese Kontakte eine hohe elektrische und mechanische Zuverlässigkeit aufweisen sollen.

Diese Aufgabe wird durch den Gegenstand des Patentanspruchs 1 gelöst.

Bevorzugte Ausgestaltungen der Erfindung sind Gegenstand der Unteransprüche.

Insbesondere wird die Aufgabe der vorliegenden Erfindung durch ein Verfahren zur Herstellung eines Trägerbandes mit einer Vielzahl von elektrischen Einheiten, jeweils aufweisend einen Chip und Kontaktelemente, gelöst, wobei die Kontaktelemente geeignet sind, direkt mit Kontaktanschlüssen externer elektrischer Bauelemente elektrisch leitend verbunden zu werden, wobei die Verbindung der Kontaktelemente mit den Chips auf dem Trägerband und somit vor einer weiteren Verarbeitung der Chips erfolgt und die Kontaktelemente aus einer auf die Chips aufzubringenden metallisierten Kunststoff-Folie bzw. metallischen Folie bestehen.

Gemäß einem besonderen Aspekt der vorliegenden Erfindung werden elektrische Einheiten, jeweils aufweisend einen Chip und Kontaktelemente, auf einem Trägerband erstellt, wobei diese Einheiten dazu dienen, eine elektrische Verbindung zwischen dem nackten Chip und einer in einem Chipkartenkörper vorhandenen Leiterschleife bzw. Antenne bereitzustellen. Die Kontaktelemente sind dabei vorzugsweise Anschlussfähnchen, die auf dem Trägerband unmittelbar mit den Anschlussflächen des Chips verbunden werden. Die vorzugsweise als Anschlussfähnchen ausgeführten Kontaktelemente haben Abmessungen, die eine problemlose Kontaktierung mit den Kontaktanschlüssen von Leiterschleifen bzw. Antennen ermöglichen, wobei die Gesamtbauhöhe der Chipkarte aufgrund der flach abstehenden Anschlussfähnchen höchstens unwesentlich vergrößert wird. Insbesondere können diese Kontaktelemente so lang ausgeführt werden, dass sie eine Verbindung des Chips mit Kontaktanschlüssen ermöglichen, die auf der gegenüberliegenden Seite der Anschlussflächen des Chips liegen, wodurch, wie weiter oben beschrieben, das im Stand der Technik übliche Umdrehen mittels Flip-Chip-Prozess vermieden wird. Die eigentliche Kontaktierung mit der Antenne kann äußerst einfach und schnell erfolgen. Des weiteren weisen die Anschlussfähnchen ein hohe mechanische Zugbelastbarkeit und somit eine große Zuverlässigkeit auf, sodass ein Aufkleben der Chips auf den Chipkartenkörper unter Umständen nicht mehr erforderlich ist, wodurch die Prozesszeiten durch ein Wegfallen der Verweilzeit beim Kleben stark verkürzt werden und sich eine Reduktion der Zugbelastungen auf den Chip selbst ergibt.

Die eigentliche Form der Kontaktelemente ergibt sich mittels Ausschneiden dieser aus der aufgebrachten Kontaktfolie, wobei das Ausschneiden vorzugsweise mittels Laser erfolgt. Alternativ hierzu kann die aufgebrachte Folie bereits vorstrukturiert sein, so dass sich umfangreiche Schneideschritte einsparen lassen. Insbesondere kann die Folie bereits in Form eines Bandes mit der gewünschten Breite der Anschlussfähnchen ausgeführt sein. Des weiteren können die Anschlussfähnchen bzw. -drähte auch mittels Wirebonder an den Anschlussflächen der Chips angebracht werden.

Neben den oben beschriebenen Vorteilen weist das angegebene Verfahren insbesondere den Vorteil auf, dass eine effiziente Erstellung von elektrischen Einheiten bereits auf dem Trägerband erfolgt und somit ein mühsames einzelnes Kontaktieren jedes individuellen Chips nicht mehr erforderlich ist. Vielmehr können quasi gleichzeitig mehrere Chips auf dem Trägerband kontaktiert werden und es kann sogar ein quasi gleichzeitiges Kontaktieren der Anschlussflächen einer Vielzahl von Chips mit einer über die Chips auf dem Trägerband gelegten Folie erreicht werden.

Die letztendlich erstellte elektrische Einheit ist äußerst robust, da die Kontaktelemente aufgrund ihrer Dimensionierung und der vorzugsweise in entsprechender Größe ausgeführten Anschlussflächen hohen Zugbelastungen standhalten, sodass die spätere Ummantelung des Chips eine weniger wichtige Rolle spielt. Insbesondere können sogenannte "Endlosbänder" erstellt werden. Eine vorteilhafte Variante besteht darin, die elektrischen Einheiten so auf das Trägerband aufzubringen, dass die Kontaktelemente orthogonal zu beiden Seiten des Trägerbandes abstehen. Dies führt zu einer äußerst einfachen Handhabung beim Einbringen der Chips in den Kartenkörper.

Des weiteren können die Kontaktelemente so mit den Anschlussflächen der Chips verbunden werden, dass sie parallel zur Oberfläche des Trägerbandes verlaufen. Somit muss, beispielsweise bei Anbringen der Anschlussfähnchen bzw. -drähte mittels Wirebonder, dieser nicht orthogonal zur Trägerbandrichtung geführt werden, da Bondrichtung und Trägerbandrichtung identisch sind. Somit können die Prozesszeiten beim Anbringen der Anschlussfähnchen bzw. -drähte wesentlich verkürzt werden, da sich ein Anhalten des Trägerbandes zum Anbringen der Anschlussfähnchen bzw. - drähte erübrigt.

Ein wesentlicher Vorteil des "Endlosbandes" mit elektrischen Einheiten beruht darauf, dass das Endlosband mit den elektrischen Einheiten aufgerollt werden kann, wodurch sowohl die Lagerung der elektrischen Einheiten, als auch deren Transport vereinfacht wird. Des weiteren entstehen keine ESD (elektro-statische Entladung) bei der Herstellung der Chipkarten selbst. Um solche Entladungen bei der Herstellung der elektrischen Einheiten auf dem Trägerband zu vermeiden, wird das Trägerband vorzugsweise geerdet. Insbesondere ist die Zuführung des Endlosbandes zur Chipplatzierung einfach über ein Zahnrad zu bewerkstelligen.

Bevorzugte Ausführungen der vorliegenden Erfindung werden im folgenden unter Bezugnahme auf die beiliegenden Zeichnungen näher erläutert. Dabei zeigen die Zeichnungen im einzelnen:
Fig. 1 eine Draufsicht auf ein Trägerband zur Aufnahme von elektrischen Einheiten;
Fig. 2 illustriert die einzelnen Verfahrensschritte zum Erstellen einer elektrischen Einheit auf einem Trägerband, gemäß einer bevorzugten Ausführungsform;
Fig. 3a bis 3d schematische Draufsichten auf ein Trägerband, die vier beispielhaft angedeutete Möglichkeiten zur Ausbildung des Trägerbandes und vier beispielhaft angedeutete Möglichkeiten zur Ausbildung von elektrischen Einheiten illustrieren;
Fig. 4 und 4a illustrieren die einzelnen Verfahrensschritte zum Erstellen einer elektrischen Einheit auf einem Trägerband, gemäß einer weiteren bevorzugten Ausführungsform;
Fig. 5 eine schematische Darstellung einer Modulkontaktierung gemäß dem Stand der Technik;
Fig. 6 eine schematische Darstellung einer Chipkontaktierung gemäß dem Stand der Technik mittels Flip-Chip-Verfahren, und
Fig. 7 eine schematische Darstellung einer Chipkontaktierung gemäß dem Stand der Technik mittels Drahtbondverfahren.

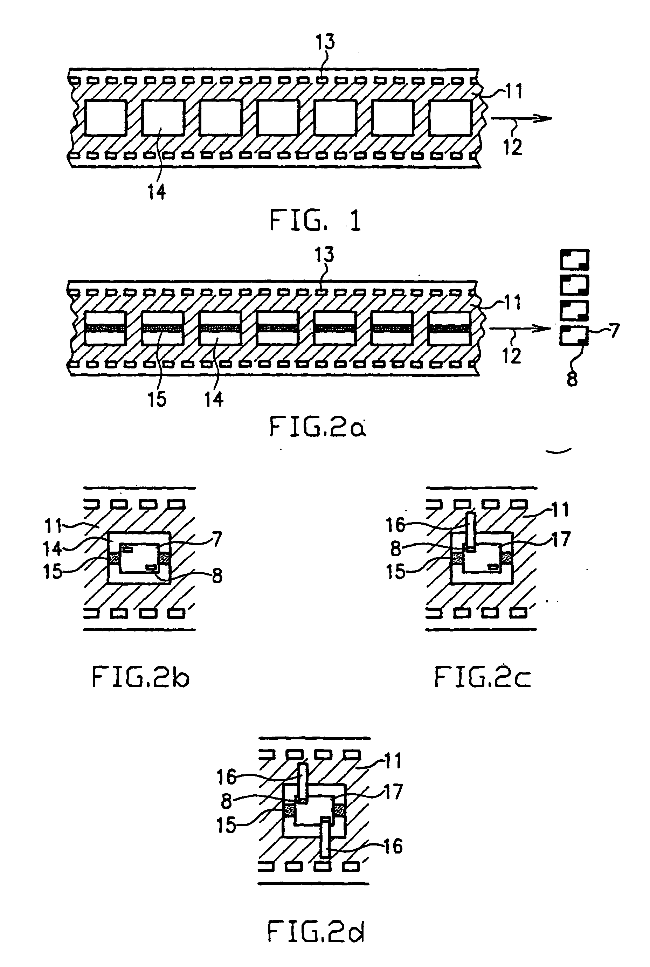

In Fig. 1 ist eine Draufsicht auf ein Trägerband 11 zur Aufnahme von elektrischen Einheiten gezeigt. Der Pfeil 12 kennzeichnet die Zuführungsrichtung, gemäß der das Trägerband 11 zu einer Chipplatzierungseinrichtung (nicht gezeigt) transportiert wird. Vorzugsweise wird als Chipplatzierungseinrichtung eine sogenannte Pick+Place-Maschine oder eine sogenannte Die-Sorter-Maschine verwendet.

Parallel zur Zuführungsrichtung 12 weist das Trägerband 11 entlang den Rändern Perforierungen 13 auf, in die ein Zahnrad (nicht gezeigt) eingreifen kann zur Zuführung des Trägerbandes 11 zu der Chipplatzierungseinrichtung. Gemäß der dargestellten bevorzugten Ausführungsform weist das Trägerband 11 an beiden Rändern Perforierungen 13 auf, wobei beispielweise auch nur an einem der beiden Ränder Perforierungen 13 angebracht sein können. Insbesondere ist es auch möglich, keine Perforierungen 13, sondern beispielsweise Verformungen anzubringen, die so ausgeführt sind, dass eine spezielle Führungseinrichtung (nicht gezeigt) das Trägerband zu der Chipplatzierungseinrichtung zuführen kann. Zentriert zwischen den Perforierungen 13 sind eine Vielzahl gleich großer und gleich beabstandeter Aussparungen 14 vorgesehen, in die jeweils ein Chip platziert werden kann. Gemäß einer besonderen Ausführungsform der vorliegenden Erfindung sind die Aussparungen 14 als Durchbrüche ausgebildet. Vorzugsweise ist das Trägerband 11 auf der Oberseite metallisiert.

Fig. 2 illustriert die einzelnen Verfahrensschritte zur Herstellung eines Trägerbandes 11 mit einer Vielzahl von elektrischen Einheiten 17, jeweils aufweisend einen Chip 7 mit Anschlussflächen 8 und Kontaktelemente 16. Gemäß der in a) dargestellten, bevorzugten Ausführungsform der vorliegenden Erfindung, weist das Trägerband 11 Durchbrüche 14 auf. Weiterhin weist das Trägerband 11 auf seiner Unterseite ein dünnes, vorzugsweise doppelseitiges Klebeband 15 auf, das etwa mittig entlang dem Trägerband 11 aufgebracht ist und somit die Durchbrüche 14 jeweils überspannt. Dies ermöglicht eine Fixierung der Chips 7 innerhalb der Durchbrüche 14, was anhand der Fig. 2 b) verdeutlicht ist.. Ein wesentlicher Vorteil der Verwendung eines doppelseitigen Klebebandes 15 zur Befestigung der Chips 7 besteht darin, dass die Chips 7 bei einer späteren Fixierung auf einer Chipkartenkörperschicht vorzugsweise aus dem Trägerband 11 mitsamt dem Klebeband 15 ausgestanzt werden können und das Klebeband 15 den Chip 7 automatisch auf der Chipkartenkörperschicht fixiert.

Zur Herstellung der elektrischen Einheiten 17 auf dem Trägerband 11 wird dieses beispielsweise mittels eines nicht gezeigten Zahnrades, das in die Perforierungen 13 eingreift, einer ebenfalls nicht gezeigten Chipplatzierungseinrichtung zugeführt. Die Chipplatzierungseinrichtung platziert jeweils einen Chip 7 in einem Durchbruch 14 des Trägerbandes 11. In einem weiteren Schritt wird vorzugsweise mittels einer Abrollvorrichtung (nicht gezeigt) eine metallisierte Kunststoff-Folie bzw. metallische Folie abgerollt. Besonders bevorzugterweise wird eine Aluminiumfolie oder eine mit Aluminium kaschierte oder bedampfte Kunststoff-Folie verwendet. Außerdem kann die Metallisierung auf der Kunststoff-Folie strukturiert sein, um hierdurch die Form der Kontaktelemente 16 bereits weitgehend vorzugeben und spätere Schneideschritte weitgehend zu vermeiden. Insbesondere kann die Folie die Form eines Bandes mit der gewünschten Breite aufweisen, wie in Fig. 2 c) und d) dargestellt, wodurch die Kontaktelemente 16 insbesondere als Anschlussfähnchen ausgeführt sein können.

Die Kontaktelemente 16 werden nun mit den Anschlussflächen 13 der einzelnen Chips 7 verbunden, was durch Löten, Bonden oder Kleben vorzugsweise während des Abrollens der Folie über das Trägerband 11 erfolgen kann. Des weiteren können die Kontaktelemente 16 auch mittels eines Wirebonders in Form von Anschlussfähnchen bzw. -drähten hergestellt werden.

Gemäß einer weiteren Ausführungsform der vorliegenden Erfindung kann die metallisierte Kunststoff-Folie bzw. metallische Folie gleichzeitig über mehrere Chips 7 auf dem Trägerband 11 gelegt werden, sodass auch ein quasi gleichzeitiges Kontaktieren der Folie mit den Anschlussflächen 8 der Chips 7 ermöglicht wird. In diesem Fall wird die Folie mittels einer Trennvorrichtung (nicht gezeigt), z. B. mittels eines Lasers, in die einzelnen Kontaktelemente 16 aufgetrennt. Andere Ausführungsformen sehen die Verbindung der Folie mit den Anschlussflächen 8 und die anschließende Trennung in die einzelnen Kontaktelemente 16 mittels einer einzigen Vorrichtung vor. Durch das Trennen der Folie in die einzelnen Kontaktelemente 16 entstehen elektrische Einheiten. Die derart entstandenen Einheiten, aufweisend jeweils einen Chip 7 mit angeschlossenen Kontaktelementen 16, wie z.B. Anschlussfähnchen, weisen neben einer einfachen und insbesondere schnellen Herstellungsart den Vorteil auf, dass der Chip später beim Einbringen in die Chipkarte nicht mehr gedreht, d.h. geflippt werden muss, da die Kontaktelemente 16 eine Verbindung zwischen den obenliegenden Anschlussflächen 8 des nichtgedrehten Chips 7 und den untenliegenden Kontaktanschlüssen einer Leiterschleife bzw. Antenne ermöglichen.

Gemäß einer bevorzugten Ausführungsform der vorliegenden Erfindung weisen die Kontaktelemente 16 an den Stellen, an denen bei der Entnahme der entsprechenden elektrischen Einheit 17 aus dem Trägerband 11 eine Trennung der Kontaktelemente 16 erfolgen soll, beispielsweise zum Aufbringen auf eine Chipkartenkörperschicht, sogenannte Sollbruchstellen (nicht gezeigt) auf. Diese Sollbruchstellen können als kleine Perforierungen oder Verengungen ausgeführt sein. Des weiteren können die Kontaktelemente 16 an den Sollbruchstellen beispielsweise mittels eines Lasers "angeritzt" werden. Ein wesentlicher Vorteil des Anbringens von Sollbruchstellen besteht darin, dass zum einen die Entnahme der elektrischen Einheit 17, vorzugsweise mittels Stanzen, erleichtert wird. Zum anderen kann somit vermieden werden, dass die Kontaktelemente 16 selbst bei der Trennung beschädigt werden, oder das die elektrische Verbindung zwischen Kontaktelement 16 und Anschlussfläche 8 beschädigt wird.

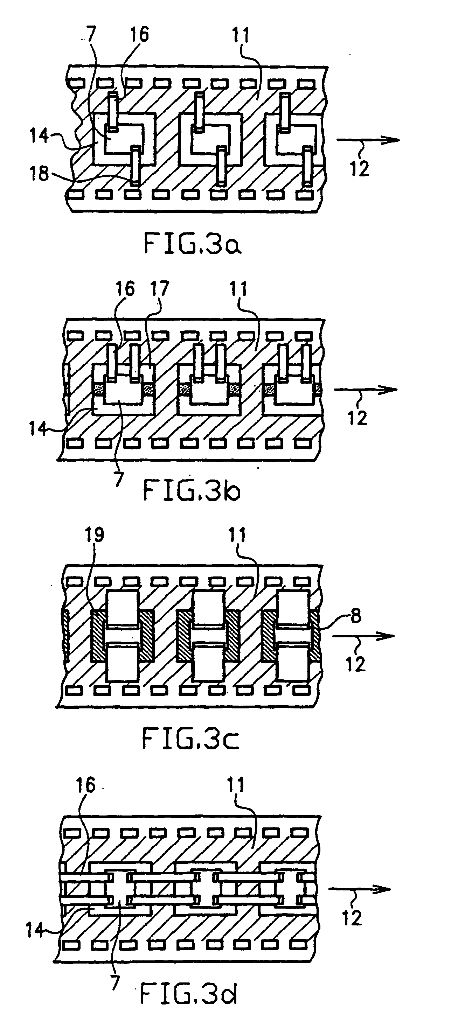

Wie in den Fig. 3a bis 3d schematisch dargestellt ist, sind verschiedene Ausführungsformen für ein Trägerband 11 zur Aufnahme von elektrischen Einheiten 17, jeweils aufweisend einen Chip 7 und Kontaktelemente 16 möglich, wobei die Figuren 3a bis 3d beispielhaft vier verschiedene Möglichkeiten illustrieren.

Fig. 3a zeigt ein Trägerband 11, in dem die Aussparungen 14 als Durchbrüche ausgeführt sind. Des weiteren ist die Oberfläche des Trägerbandes 11 metallisiert, sodass in diesem Fall eine Befestigung der Chips 7 durch die Kontaktelemente 16 erfolgt, wobei die Kontaktelemente 16 mittels Löten, Bonden oder Kleben an den Stellen 18 mit dem Trägerband 11 verbunden werden.

Fig. 3b zeigt ein Trägerband 11, das bereits in den Erläuterungen zu Fig. 2 beschrieben wurde. In diesem Fall kann ebenfalls eine Befestigung der Chips 7 auf dem Trägerband 11 erfolgen, um die Verbindung der Chips 7 mit dem Klebeband 15 zu stabilisieren.

Fig. 3c zeigt ein Trägerband 11, bei dem die Aussparungen 14 nicht als Durchbrüche ausgeführt sind und somit steht eine Auflagefläche 19 für die Chips 7 zur Verfügung. Zur weiteren Fixierung der Chips 7 können die Kontaktelemente 16 wiederum mittels Löten, Bonden oder Kleben mit dem Trägerband 11 verbunden werden. Insbesondere kann die Auflagefläche 19 eine Folie sein, die mit der Rückseite des Trägerbandes 11 verbunden ist, für den Fall, dass ein Trägerband 11 verwendet wird, bei dem die Aussparungen 14 als Durchbrüche ausgeführt sind.

Fig. 3d zeigt ein Trägerband 11, das bereits in den Erläuterungen zu Fig. 3a beschrieben wurde. Zur weiteren Fixierung der Chips 7 können die Kontaktelemente 16 wiederum mittels Löten, Bonden oder Kleben mit dem Trägerband 11 verbunden werden. Für den Fall, dass die Oberfläche des Trägerbandes 11 nicht metallisiert ist, erfolgt eine Fixierung der Chips 7 auf dem Trägerband 11 durch die Kontaktelemente 16 selbst, die die einzelnen Chips 7 miteinander verbinden.

Die beispielhaft angedeuteten Möglichkeiten zur Ausbildung von elektrischen Einheiten sind bedingt durch die verschiedenen Anordnungsmöglichkeiten der Anschlussflächen 8 auf den Chips 7. Auch andere Anordnungen, wie beispielsweise ein diagonales Aufbringen der Kontaktelemente 8 auf einen Chip 7, dessen Anschlussflächen analog zu Fig. 3a ausgebildet sind, sind möglich.

Die Fig. 4 und 4a illustrieren die einzelnen Verfahrensschritte zur Herstellung eines Trägerbandes 11 mit einer Vielzahl von elektrischen Einheiten 17, jeweils aufweisend einen Chip 7 mit Anschlussflächen 8 und Kontaktelemente 16, gemäß einer weiteren besonderen Ausführungsform der vorliegenden Erfindung.

Fig. 4 zeigt die Unterseite eines Trägerbandes 11, wobei die Aussparungen 14 als Durchbrüche ausgeführt sind und auf der Oberseite des Trägerbandes 11 eine metallisierte Kunststoff-Folie bzw. metallische Folie 20 ausgebildet ist. Gemäß Fig. 4 b) werden die Chips 7 derart in die Aussparungen 14 eingebracht, dass die Anschlussflächen 8 die Folie 20 berühren. Anschließend werden die Folie 20 und die Anschlussflächen 8 miteinander verbunden.

Zum Ausbilden der Kontaktelemente 16 kann die Folie vorzugsweise entlang den Trennlinien 21 durchtrennt werden.

In den obenstehend beschriebenen Ausführungsformen kann das Erstellen der elektrischen Verbindung zwischen der Folie und den Anschlussflächen 8 der entsprechenden Chips 7 auf verschiedene Arten erfolgen. Möglichkeiten hierzu sind Druck, Temperatur, Ultraschall, Kleben, Löten oder Schweißen. Ein Ausbilden einzelner Kontaktelemente 16 aus einer Folie kann jeweils vor, während oder nach dem Erstellen dieser elektrischen Verbindung erfolgen, vorzugsweise mittels eines Lasers.

Ein prinzipieller Vorteil des Aneinanderreihens von elektrischen Einheiten 17 auf Trägerbänder 11 ist, dass die weitere Verarbeitung dieser Einheiten 17 in einer guten Transportfähigkeit sowie in einer einfachen maschinellen Handhabung besteht.

## Patentansprüche

1. Verfahren zur Herstellung eines Trägerbandes (11) mit einer Vielzahl von elektrischen Einheiten (17), wobei das Trägerband (11 ) für die Transponderherstellung vorgesehen ist und das Verfahren die folgenden Schritte aufweist:
Bereitstellen einer Vielzahl vorgefertigter Chips (7) mit zumindest einer Anschlussfläche (8);
Bereitstellen eines Trägerbandes (11 ) zur Aufnahme der Chips (7);
Zuführen des Trägerbandes (11 ) zu einer Chipplatzierungseinrichtung,
Platzierung von zumindest einem Chip (7) auf das Trägerband (11),
**gekennzeichnet durch**
Bereitstellen einer metallisierten Kunststoff-Folie bzw. metallischen Folie zum Ausbilden von zumindest einem Kontaktelement (16);
Zuführen der metallisierten Kunststoff-Folie bzw. metallischen Folie zu dem Trägerband (11 ),
Verbinden der metallisierten Kunststoff-Folie bzw. metallischen Folie mit der zumindest einen Anschlussfläche (8) des zumindest einen Chips (7) zum Erstellen einer elektrischen Einheit (17) aus Chip (7) und Kontaktelement (16).

2. Verfahren nach Anspruch 1, **dadurch gekennzeichnet, dass** die auf die Chips (7) aufzubringende, metallisierte Kunststoff-Folie bzw. metallische Folie mit dem Trägerband ( 11 ) verbunden wird.

3. Verfahren nach Anspruch 1 oder 2, **dadurch gekennzeichnet, dass** die auf die Chips (7) aufzubringende, metallisierte Kunststoff-Folie bzw. metallische Folie strukturiert ist, um dadurch die Form des zumindest einen Kontaktelements (16) vorzudefinieren.

4. Verfahren nach einem der Ansprüche 1 bis 3, **dadurch gekennzeichnet, dass** die auf die Chips (7) aufzubringende, metallisierte Kunststoff-Folie bzw. metallische Folie aus Aluminium, Gold oder Kupfer ist.

5. Verfahren nach einem der Ansprüche 1 bis 4, **dadurch gekennzeichnet, dass** die auf die Chips (7) aufzubringende, metallisierte Kunststoff-Folie bzw. metallische Folie mindestens die Breite der zumindest einen Anschlussfläche (8) aufweist.

6. Verfahren nach einem der Ansprüche 1 bis 5, **dadurch gekennzeichnet, dass** die Verbindung der Folie mit den einzelnen Chips (7) an mindestens zwei Anschlussflächen (8) jedes einzelnen Chips (7) erfolgt.

7. Verfahren nach Anspruch 6, **dadurch gekennzeichnet, dass** die Verbindung der Folie mit den einzelnen Chips (7) an zwei Anschlussflächen (8) jedes einzelnen Chips (7) erfolgt und die zwei Anschlussflächen (8) jeweils in gleichem Abstand zu einer Seite des jeweiligen Chips (7) angeordnet sind.

8. Verfahren nach Anspruch 6, **dadurch gekennzeichnet, dass** die Verbindung der Folie mit den einzelnen Chips (7) an zwei Anschlussflächen (8) jedes einzelnen Chips (7) erfolgt und die zwei Anschlussflächen (8) jeweils in unterschiedlichen Abständen zu einer Seite des jeweiligen Chips (7) angeordnet sind, wobei die zwei Anschlussflächen (8) des jeweiligen Chips (7) diagonal versetzt angeordnet sind.

9. Verfahren nach Anspruch 8, **dadurch gekennzeichnet, dass** die Breite der Anschlussflächen (8) etwa der Breite des Chips (7) entspricht und die zwei Anschlussflächen (8) des jeweiligen Chips (7) an gegenüberliegenden Seiten des jeweiligen Chips (7) angeordnet sind.

10. Verfahren nach Anspruch 6, **dadurch gekennzeichnet, dass** die Verbindung der Kontaktelemente (16) mit den einzelnen Chips (7) an vier Anschlussflächen (8) jedes einzelnen Chips (7) erfolgt, wobei die Anschlussflächen (8) jeweils in den Ecken des jeweiligen Chips (7) liegen.

11. Verfahren nach einem der Ansprüche 7 bis 10, **gekennzeichnet durch** die folgenden Schritte,
Verbinden der metallisierten Kunststoff-Folie bzw. metallischen Folie mit einer Seite des Trägerbandes (11 ),
Abrollen der Folie (16) jeweils entsprechend einer beabsichtigten Länge zwischen dem Trägerband und der ersten Anschlussfläche (8),
Verbinden der Folie (16) mit der ersten Anschlussfläche (8),
Schneiden der Folie (16).

12. Verfahren nach Anspruch 11, **dadurch gekennzeichnet, dass** die metallisierte Kunststoff-Folie bzw. metallische Folie ein Draht ist.

13. Verfahren nach Anspruch 11 oder 12, **dadurch gekennzeichnet, dass** das Verbinden der Chips (7) mit der metallisierten Kunststoff-Folie bzw. metallischen Folie durch einen Löt-, Bond- oder Klebeprozess ausgeführt wird.

14. Verfahren nach einem der Ansprüche 11 bis 13, **dadurch gekennzeichnet, dass** das Schneiden der metallisierten Kunststoff-Folie bzw. metallischen Folie mittels eines Lasers erfolgt.

15. Verfahren nach einem der Ansprüche 1 bis 14, **dadurch gekennzeichnet, dass** das Trägerband (11 ) zur Vermeidung elektro-statischer Entladungen geerdet wird.

## Claims

1. Method for the manufacture of a carrier tape (11 ) with a plurality of electrical units (17) whereby the carrier tape (11) is provided for the manufacture of transponders and the method comprises the following steps:
provision of a plurality of prefabricated chips (7) with at least one connection surface (8);
provision of a carrier tape (11) for the accommodation of the chips (7);
feeding of the carrier tape (11) to a chip placement device;
placement of at least one chip (7) on the carrier tape (11);
**characterized by**
provision of a metallized plastic foil or metaflic foil for the formation of at least one contact element (16);
feeding of the metallized plastic foil or metallic foil to the carrier tape (11);
joining of the metallized plastic foil or metallic foil with the at least one connection surface (8) of the at least one chip (7) for the production of an electrical unit (17) from chip (7) and contact element (16).

2. Method according to Claim 1, **characterized in that** the metallized plastic foil or metallic foil to be fitted to the chips (7) is joined to the carrier tape (11 ).

3. Method according to Claim 1 or 2, **characterized in that** the metallized plastic foil or metallic foil to be fitted to the chips (7) is structured in order to predefine the shape of the at least one contact element (16).

4. Method according to one of the Claims 1 to 3, **characterized in that** the metallized plastic foil or metallic foil to be fitted to the chips (7) is of aluminum, gold or copper.

5. Method according to one of the Claims 1 to 4, **characterized in that** the metallized plastic foil or metallic foil to be fitted to the chips (7) exhibits at least the width of the at least one connection surface (8).

6. Method according to one of the Claims 1 to 5, **characterized in that** the joining of the foil with the individual chips (7) occurs on at least two connection surfaces (8) of each individual chip (7).

7. Method according to Claim 6, **characterized in that** the joining of the foil with the individual chips (7) occurs on two connection surfaces (8) of each individual chip (7) and the two connection surfaces (8) are each arranged at the same distance to one side of the relevant chip (7).

8. Method according to Claim 6, **characterized in that** the joining of the foil with the individual chips (7) occurs on two connection surfaces (8) of each individual chip (7) and the two connection surfaces (8) are each arranged at different distances to one side of the relevant chip (7), whereby the two connection surfaces (8) of the relevant chip (7) are diagonally offset.

9. Method according to Claim 8, **characterized in that** the width of the connection surfaces (8) corresponds approximately to the width of the chips (7) and the two connection surfaces (8) of the relevant chip (7) are arranged on opposite sides of the relevant chip (7).

10. Method according to Claim 6, **characterized in that** the joining of the contact elements (16) to the individual chips (7) occurs on four connection surfaces (8) of each individual chip (7), whereby the connection surfaces (8) in each case are located in the comers of the relevant chip (7).

11. Method according to one of the Claims 7 to 10, **characterized by** the following steps:
connection of the metallized plastic foil or metallic foil with one side of the carrier tape (11);
unrolling of the foil (16) in each case according to an intended length between the carrier tape and the first connection surface (8);
joining of the foil (16) with the first connection surface (8);
cutting of the foil (16).

12. Method according to Claim 11, **characterized in that** the metallized plastic foil or metallic foil is a wire.

13. Method according to Claim 11 or 12, **characterized in that** the joining of the chips (7) to the metallized plastic foil or metallic foil is carried out by a soldering, bonding or adhesive process.

14. Method according to one of the Claims 11 to 13, **characterized in that** the cutting of the metallized plastic foil or metallic foil occurs using a laser.

15. Method according to one of the Claims 1 to 14, **characterized in that** the carrier tape (11) is earthed to avoid electro-static discharges.

## Revendications

1. Procédé pour fabriquer une bande support (11) dotée d'une pluralité d'unités électriques (17), la bande support étant prévue pour la fabrication de transpondeurs et le procédé comportant les étapes suivantes :
- mise à disposition d'une pluralité de puces préalablement préparées (7) comprenant au moins une surface de raccordement (8) ;
- mise à di spos i t ion d'une bande support (11) pour recevoir les puces (7) ;
- transport de la bande support (11) vers un dispositif de mise en place des puces ;
- mise en place d'au moins une puce (7) sur la bande support (11),
**caractérisé par** :
- la mise à disposition d'une feuille en matériau synthétique métallisée ou d'une feuille métallique pour former au moins un élément de contact (16) ;
- le transport de la feuille en matériau synthétique métallisée ou de la feuille métallique vers la bande support (11) ;
- l'assemblage de la feuille en matériau synthétique métallisée ou de la feuille métallique avec l'au moins une surface de raccordement (8) de l'au moins une puce (7) pour réaliser une unité électrique (17) à partir de la puce (7) et de l'élément de contact (16).

2. Procédé selon la revendication 1, **caractérisé en ce que** la feuille en matériau synthétique métallisée ou la feuille métallique à placer sur les puces (7) est reliée à la bande support (11).

3. Procédé selon la revendication 1 ou 2, **caractérisé en ce que** la feuille en matériau synthétique métallisée ou la feuille métallique à placer sur les puces (7) est structurée pour réaliser ainsi une définition préliminaire de la forme de l'au moins un élément de contact (16).

4. Procédé selon l'une quelconque des revendications 1 à 3, **caractérisé en ce que** la feuille en matériau synthétique métallisée ou la feuille métallique à placer sur les puces (7) est constituée d'aluminium, d'or ou de cuivre.

5. Procédé selon l'une quelconque des revendications 1 à 4, **caractérisé en ce que** la feuille en matériau synthétique métallisée ou la feuille métallique à placer sur les puces (7) a au moins la largeur de l'au moins une surface de raccordement (8).

6. Procédé selon l'une quelconque des revendications 1 à 5, **caractérisé en ce que** l'assemblage de la feuille avec les différentes puces (7) a lieu sur au moins deux surfaces de raccordement (8) de chaque puce individuelle (7).

7. Procédé selon la revendication 6, **caractérisé en ce que** l'assemblage de la feuille avec les différentes puces (7) a lieu sur deux surfaces de raccordement (8) de chaque puce individuelle (7) et **en ce que** les deux surfaces de raccordement (8) sont disposées respectivement avec le même espacement par rapport à un côté de l a puce respective (7).

8. Procédé selon la revendication 6, **caractérisé en ce que** l'assemblage de la feuille avec les différentes puces (7) a lieu sur deux surfaces de raccordement (8) de chaque puce individuelle (7) et **en ce que** les deux surfaces de raccordement (8) sont disposées respectivement avec des espacements différents par rapport à un côté de la puce respective (7), les deux surfaces de raccordement (8) de la puce respective (7) étant disposées avec un décalage en diagonale.

9. Procédé selon la revendication 8, **caractérisé en ce que** la largeur des surfaces de raccordement (8) correspond approximativement à la largeur de la puce (7) et **en ce que** les deux surfaces de raccordement (8) de la puce respective (7) sont disposées sur des côtés opposés de la puce respective (7).

10. Procédé selon la revendication 6, **caractérisé en ce que** l'assemblage des éléments de contact (16) avec les différentes puces (7) a lieu sur quatre surfaces de raccordement (8) de chaque puce individuelle (7), les surfaces de raccordement (8) se trouvant respectivement dans les angles de la puce respective (7).

11. Procédé selon l'une quelconque des revendications 7 à 10, **caractérisé par** les étapes suivantes :
- assemblage de la feuille en matériau synthétique métallisée ou de la feuille métallique avec un côté de la bande support (11) ;
- déroulement de la feuille (16) respectivement selon une longueur prévue entre la bande support et la première surface de raccordement (8) ;
- assemblage de la feuille (16) avec la première surface de raccordement (8) ;
- découpe de la feuille (16).

12. Procédé selon la revendication 11, **caractérisé en ce que** la feuille en matériau synthétique métallisée ou la feuille métallique est un fil.

13. Procédé selon la revendication 11 ou 12, **caractérisé en ce que** l'assemblage des puces (7) avec la feuille en matériau synthétique métallisée ou la feuille métallique a lieu par un procédé de soudage, de liaison ou de collage.

14. Procédé selon l'une quelconque des revendications 11 à 13, **caractérisé en ce que** la découpe de la feuille en matériau synthétique métallisée ou de la feuille métallique a lieu à l'aide d'un laser.

15. Procédé selon l'une quelconque des revendications 1 à 14, **caractérisé en ce que**, pour éviter les décharges électrostatiques, la bande support (11) est mise à la terre.
